# EUROPÄISCHE PATENTSCHRIFT

(11) **EP 1 099 308 B1**
(45) Veröffentlichungstag und Bekanntmachung des Hinweises auf die Patenterteilung: **26.04.2006**
(21) Anmeldenummer: 99952274.1
(22) Anmeldetag: 02.08.1999
(51) Int. Cl.: H03K 19/0944, H03K 19/0175, H03K 19/003

(54) **TREIBERSCHALTUNG**
DRIVING CIRCUIT
CIRCUIT D'ATTAQUE

(30) Priorität: 18.08.1998 DE 19837393
(43) Veröffentlichungstag der Anmeldung: 16.05.2001
(73) Patentinhaber: Infineon Technologies AG, 81669 München (DE)
(72) Erfinder: WERKER, Heinz, D-82386 Huglfing (DE); KILLAT, Dirk, D-73230 Kirchhheim (DE); HAASE, Ordwin, D-85521 Ottobrunn (DE); GRÖPL, Martin, D-81541 München (DE)
(74) Vertreter: Barth, Stephan Manuel
(86) Internationale Anmeldenummer: PCT/DE1999/002416
(87) Internationale Veröffentlichungsnummer: WO 2000/011788

(56) Entgegenhaltungen:
- EP-A- 0 332 077
- EP-A- 0 427 557
- EP-A- 0 529 118
- US-A- 5 362 998
- US-A- 5 363 063
- US-A- 5 541 799

## Beschreibung

Die Erfindung betrifft eine Treiberschaltung nach dem Oberbegriff von Patentanspruch 1, wie aus der US-A-5,363,063 bekannt.

Treiberschaltungen werden in integrierten Schaltungen zum Treiben von Bausteinanschlüssen (Pins) verwendet. Abhängig von der zu treibenden. Last muß eine Treiberschaltung verschiedene Anforderungen wie beispielsweise eine hohe Stromtreiberfähigkeit oder eine präzise Strombegrenzung erfüllen. Insbesondere bei der ISDN-S0-Schnittstelle bestehen zwei Anforderungen, die spezielle Treiberschaltungen erfordern. Einerseits muß der zu treibende Strom auf einen maximalen Wert präzise begrenzt werden und andererseits sollte bei abgeschalteter Versorgungsspannung des treibenden ISDN-S0-Schnittstellenbausteins die Treiberschaltung bei einer am Pin anliegenden externen Spannung hochohmig sein.

Bei "An ISDN S-Interface Transceiver with analog Timing Recovery", P.Gillingham, D.Kirkey, J.Errku, ISSCC 88, IEEE International Solid-State Circuit Conference, S.108-109 und S.317, ist die Treiberschaltung durch zwei große Treibertransistoren realisiert. Der Strom durch die Treibertransistoren wird über Stromspiegel in diese gespiegelt, wobei die Stromspiegel von einem temperaturkompensierten, über Schmelzsicherungen auf dem Baustein eingestellten Strom gespeist werden. Nachteilig ist bei dieser Lösung, daß nach einer Einstellung der Schmelzsicherungen der Strom auf einen fest vorgegebenen, nicht mehr änderbaren Wert festgelegt ist.

Aus "An ISDN S-Interface Transceiver for Public and Private Digital Loops", F.Van Simaeys, J.Adams, D.Rabaey, S.233-236, ESSCIRC'88 ist eine ISDN-S0-Schnittstellenschaltung bekannt, bei der eine Treiberschaltung eine spannungsbegrenzte Stromquelle aufweist, die große Treibertransistoren umfaßt. Bei einem Strom von 7,5 mA gehen die Treibertransistoren in Sättigung und begrenzen somit den Strom. Nachteilig ist bei einer solchen Lösung, daß die Strombegrenzung vom Sättigungsstrom der Treibertransistoren abhängig und damit relativ ungenau ist.

Das der Erfindung zugrundeliegende Problem besteht daher darin, eine Treiberschaltung anzugeben, die eine präzise Strombegrenzung aufweist und bei abgeschalteter Versorgungsspannung in einen hochohmigen Zustand geht.

Dieses Problem wird durch eine Treiberschaltung mit Merkmalen von Patentanspruch 1 gelöst. Vorteilhafte Ausgestaltungen der Treiberschaltungen ergeben sich aus den abhängigen Ansprüchen.

Ein Ausführungsform der Erfindung betrifft eine Treiberschaltung, die einen ersten und zweiten Transistor aufweist. Die Laststrecke des ersten Transistors ist zwischen eine erste Versorgungsspannung und einem Treiberschaltungsausgang geschaltet. Die Laststrecke des zweiten Transistors ist zwischen einer zweiten Versorgungsspannung und dem Treiberschaltungsausgang geschaltet. Einer der beiden Treibertransistoren ist dabei als Feldeffekttransistor ausgeführt, während der andere Treibertransistor als bipolarer Transistor ausgeführt ist. Dadurch wird vorteilhafterweise vermieden, daß bei abgeschalteter Versorgungsspannung der Treiberschaltung entweder die Basis-Emitter-Diode des bipolaren Transistors oder eine parasitäre Diode des Feldeffekttransistors leitet und ständig ein Strom über die Treiberschaltung fließt.

Der erste Transistor ist als p-Kanal-MOSFET oder p-Kanal-Sperrschicht-Feldeffekttransistor und der zweite Transistor als pnp-Bipolartransistor in einer bevorzugten Ausführungsform ausgeführt. Der Vorteil dieser Schaltung liegt darin, daß die durch den P⁺N-Übergang am Drain-Anschluß des p-Kanal-MOSFET oder die durch den Drain-Gate-PN-Übergang des p-Kanal-Sperrschicht-Feldeffekttransistors und die durch den Emitter-Basis-PN-Übergang des pnp-Bipolartransistors gebildete Diode, die mit dem Treiberschaltungsausgang verbunden ist, sperrt, wenn am Treiberschaltungsausgang eine negative Spannung anliegt und die Versorgungsspannung der Treiberschaltung abgeschaltet ist. Dadurch wird vermieden, daß bei negativen Spannungen am Treiberschaltungsausgang und bei abgeschalteter Versorgungsspannung ein Strom in die Treiberschaltung fließt.

In einer anderen Ausführungsform der Treiberschaltung ist der erste Treibertransistor als npn-Bipolartransistor und der zweite Treibertransistor als n-Kanal-MOSFET oder n-Kanal-Sperrschicht-Feldeffekttransistor ausgeführt. Hierbei sperrt die durch den N⁺P-Übergang des n-Kanal-MOSFET oder die durch den Drain-Gate-NP-Übergang des n-Kanal-Sperrschicht-Feldeffekttransistors und den NP-Übergang des npn-Bipolartransistors gebildete Diode bei einer positiven Spannung am Treiberschaltungsausgang.

Besonders bevorzugt wird eine Kombination zweier Treiberschaltungen nach der Erfindung zur Ansteuerung der ISDN-S0-Schnittstelle. Da bei der Ansteuerung von Zweidrahtleitungen über Übertragerschaltungen immer eine der beiden Treiberschaltungen hochohmig ist, sperren die beiden Treibertransistoren bei einer der beiden Treiberschaltungen immer und die ISDN-S0-Schnittstelle verbraucht bei abgeschalteter Versorgungsspannung wenig Strom und erfüllt somit die Bedingung für Hochohmigkeit.

Die Erfindung schafft eine Treiberschaltung, die zwei Treibertransistoren und eine Strombegrenzereinrichtung aufweist. Die Strombegrenzereinrichtung begrenzt den Strom durch einen Treibertransistor präzise auf einen einstellbaren Wert. Vorteilhafterweise weist die Strombegrenzereinrichtung eine wesentlich höhere Ansprechgeschwindigkeit auf als die Treiberansteuerung, so daß insbesondere bei induktiven und kapazitiven Lasten eine Kompensation auftritt.

In einer bevorzugten Ausführungsform ist ein Regeleingang der Strombegrenzereinrichtung mit einem Ausgang der Treiberschaltung verbunden, so daß die Strombegrenzung durch diese Gegenkopplung bei niederohmigen Lasten früher und bei normalen oder hochohmigen Lasten später einsetzt. Dabei kann die zulässige Pulsmaske für die ISDN-S0-Schnittstelle noch präziser eingestellt werden.

In einer weiteren Ausführungsform ist der Regeleingang der Strombegrenzereinrichtung auf ein festes, vorgebbares Potential eingestellt, so daß die Strombegrenzung bei allen Lasten gleich einsetzt.

Eine bevorzugte Ausführungsform der Strombegrenzereinrichtung weist einen Transistor und eine dazu in Serie geschaltete Stromquelle auf. Der Transistor wird als Spiegeltransistor zu einem der beiden Treibertransistoren benutzt, so daß der durch die Stromquelle festgelegte Strom in den Treibertransistor gespiegelt wird.

Erfindungsgemäß weist die Strombegrenzereinrichtung eine source-gekoppelte Differenzstufe auf, wobei ein erster Eingang der Differenzstufe mit einem Anschluß des Spiegeltransistors und ein zweiter Eingang mit dem Regeleingang verbunden ist. Die Last der Differenzstufe besteht aus einem ersten und einem zweiten als Dioden geschalteten Lasttransistor, wobei der Steueranschluß des ersten Lasttransistors mit dem Steueranschluß eines Steuertransistors verbunden ist. Der Steuertransistor stellt die Spannung am Steueranschluß eines Treibertransistors und des Spiegeltransistors ein und begrenzt damit den Strom durch den Treibertransistor.

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigen
- Fig.1: ein erstes Ausführungsbeispiel einer Treiberschaltung nach der Erfindung;
- Fig.2: ein Ausführungsbeispiel einer Strombegrenzereinrichtung;
- Fig.3A: ein zweites Ausführungsbeispiel einer Treiberschaltung nach der Erfindung;
- Fig.3B: ein drittes Ausführungsbeispiel einer Treiberschaltung nach der Erfindung; und
- Fig.4: ein Ausführungsbeispiel einer Treiberschaltung einer ISDN-S0-Schnittstelle.

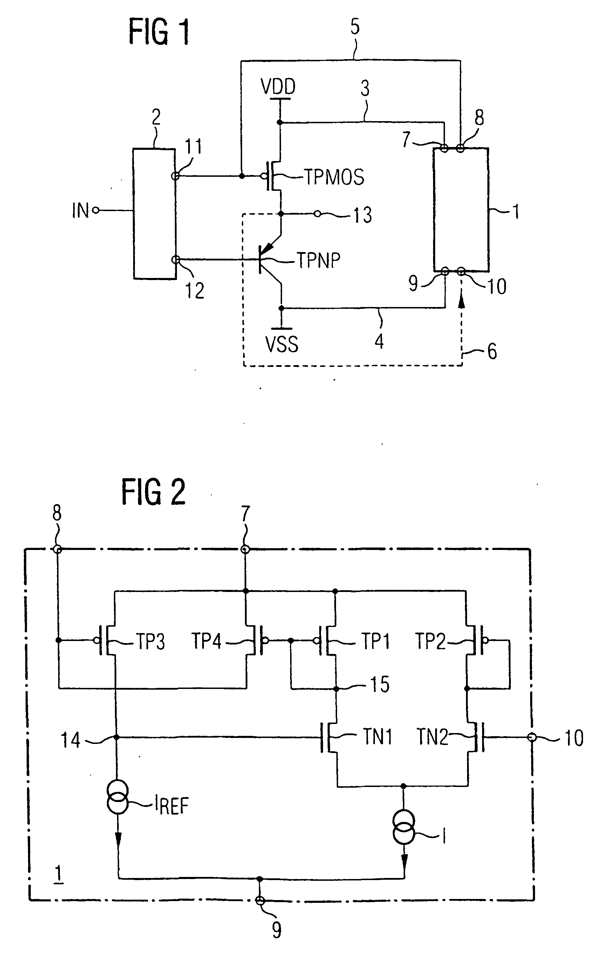

Gemäß Fig.1 weist eine Treiberansteuerung 2 einen Eingang IN und einen ersten Ausgang 11 und einen zweiten Ausgang 12 auf. Der erste Ausgang 11 ist mit dem Steueranschluß eines p-Kanal-MOS-Treibertransistors TPMOS verbunden. Der zweite Ausgang 12 ist mit dem Steueranschluß eines pnp-Bipolar-Treibertransistors TPNP verbunden. Die Laststrecke des ersten Treibertransistors TPMOS ist zwischen eine erste Versorgungsspannung VDD und einem Treiberschaltungsausgang 13 geschaltet. Die Laststrecke des zweiten Treibertransistors TPNP ist zwischen eine zweite Versorgungsspannung VSS und dem Treiberschaltungsausgang 13 geschaltet. Eine Ausführung beider Treibertransistoren in MOS-Technologie oder in Bipolar-Technologie ist möglich. Üblicherweise ist in digitalen Schaltungen die erste Versorgungsspannung VDD 5 V und die zweite Versorgungsspannung VSS 0 V, es können aber auch andere Versorgungsspannungen wie beispielsweise für die erste Versorgungsspannung VDD 3,3 V bei Einsatz von 3 V-Technologien gewählt werden.

Ein erster Anschluß 7 einer Strombegrenzereinrichtung 1 ist mit der ersten Versorgungsspannung VDD zur Stromversorgung verbunden. Über einen zweiten Anschluß 9 ist die Strombegrenzereinrichtung 1 mit der zweiten Versorgungsspannung VSS verbunden. Ein bidirektionaler Steueranschluß 8 der Strombegrenzereinrichtung 1 ist über eine Steuerleitung 5 mit dem Steueranschluß des p-Kanal-MOS-Transistors TPMOS verbunden. Über die Einstellung der Steuerspannung des Treibertransistors kann die Strombegrenzereinrichtung den Strom durch den Treibertransistor begrenzen. In anderen Ausführungsbeispielen kann der bidirektionale Steueranschluß 8 der Strombegrenzereinrichtung 1 auch mit dem Steueranschluß des pnp-Bipolartransistors TPNP zur Strombegrenzung verbunden sein. Ein Regeleingang 10 der Strombegrenzereinrichtung 1 dient zur Gegenkopplung und ist über eine Leitung 6 (in Fig.1 gestrichelt dargestellt) mit der Treiberschaltungsausgang 13 verbunden. Durch die Gegenkopplung wird eine lastabhängige Strombegrenzung erreicht. Der Regeleingang 10 kann auch mit einer festen Spannung verbunden werden, wobei keine Gegenkopplung mehr stattfindet.

Die Strombegrenzereinrichtung regelt im Betrieb der Treiberschaltung den Strom durch den ersten Transistor TPMOS so, daß durch eine Einstellung der Steuerspannung des Treibertransistors der Strom durch den Transistor auf einen Höchstwert begrenzt wird.

In Fig.2 ist ein Ausführungsbeispiel der Strombegrenzereinrichtung in MOS-Technologie dargestellt. Die Strombegrenzereinrichtung wird über einen ersten Anschluß 7 mit der ersten Versorgungsspannung VDD der Treiberschaltung und über einen zweiten Anschluß 9 mit der zweiten Versorgungsspannung VSS der Treiberschaltung verbunden. Ein Spiegeltransistor TP3, der ein p-Kanal-MOSFET ist, ist mit einer Referenzstromquelle IREF in Serie geschaltet. Der Spiegeltransistor bildet den p-Kanal-MOS-Treibertransistor TPMOS nach. Die Referenzstromquelle IREF gibt den maximalen Strom durch den Spiegeltransistor TP3 vor. Dieser Strom IREF wird in den p-Kanal-MOS-Treibertransistor TPMOS gespiegelt. Beträgt das Spiegelverhältnis beispielsweise 1:20, so bewirkt ein Referenzstrom IREF von 1 mA einen maximalen Strom von 20 mA durch den p-Kanal-MOS-Treibertransistor. Die Spannung, die sich bei einem Referenzstrom IREF an einem Knoten 14 einstellt, wird an den Steueranschluß eines ersten n-Kanal-MOSFET's TN1 einer Differenzverstärkerstufe übertragen und von der Differenzverstärkerstufe mit einem Potential verglichen, das am Steueranschluß eines zweiten n-Kanal-MOSFET's TN2 der Differenzverstärkerstufe über den Regeleingang 10 anliegt. Der Ausgang der Differenzverstärkerstufe ist über einen Steuertransistor TP4 auf den Steueranschluß des Spiegeltransistors TP3 rückgekoppelt. Ein erster p-Kanal-MOSFET TP1 und ein zweiter p-Kanal-MOSFET TP2 ist jeweils als Diode geschaltet und bildet einen Lastelement für den ersten n-Kanal-MOSFET TN1 und zweiten n-Kanal-MOSFET TN2 der Differenzstufe. Der Steuertransistor TP4, dessen Laststrecke zwischen die erste Versorgungsspannung VDD und einen Steueranschluß 8 geschaltet ist, steuert die Spannung am Steueranschluß des Spiegeltransistors TP3 und über einen Steueranschluß 8 die Steuerspannung des p-Kanal-MOS-Transistors TPMOS.

Wenn durch den p-Kanal-MOS-Treibertransistor TPMOS ein höherer Strom fließen soll, sinkt die Steuerspannung am Steueranschluß des Treibertransistors. Gleichzeitig sinkt die Steuerspannung am Steueranschluß des Spiegeltransistors TP3 und das Potential am Knoten 14 steigt. Übersteigt das Potential am Knoten 14 das Potential am Regeleingang 10, so steigt die Ausgangsspannung der Differenzverstärkerstufe und die Steuerspannung am Steueranschluß des Steuertransistors TP4. Der Steuertransistor TP4 verringert somit die Steuerspannung des Spiegeltransistors TP3 und des p-Kanal-MOS-Treibertransistors TPMOS, so daß der Strom durch den Treibertransistor begrenzt wird.

Der Regeleingang 10 kann nun mit einer festen Spannung wie beispielsweise (VDD+VSS)/2 verbunden werden, so daß die Strombegrenzung unabhängig von der Last immer gleich einsetzt. Wird der Regeleingang 10 mit dem Treiberschaltungsausgang 13 verbunden, erhält man eine Gegenkopplung. Dabei setzt die Strombegrenzung abhängig von der Last bei niederohmigen Lasten früher und bei normalen oder hochohmigen Lasten später ein. Dadurch wird die Strombegrenzung noch präziser.

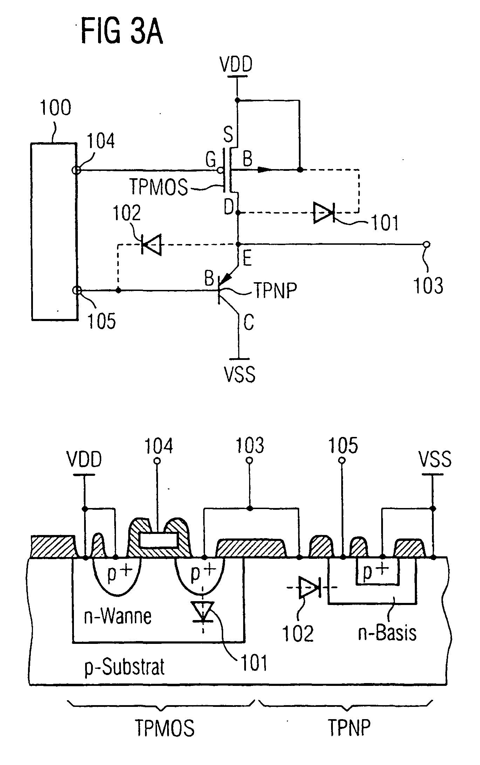

Fig.3A zeigt ein Ausführungsbeispiel einer integrierten Treiberschaltung, die eine Treiberansteuerung 100, einen p-Kanal-MOSFET TPMOS und einen pnp-Bipolartransistor TPNP aufweist. Der Gate-Anschluß des p-Kanal-MOSFET ist mit einem ersten Ausgang 104 der Treiberansteuerung und die Basis des pnp-Bipolartransistors TPNP ist mit einem zweiten Ausgang 105 der Treiberansteuerung verbunden. Die Laststrecke des p-Kanal-MOSFET ist zwischen der ersten Versorgungsspannung VDD und einem Treiberschaltungsausgang 103 geschaltet. Die Laststrekke des pnp-Bipolartransistors TPNP ist zwischen der zweiten Versorgungsspannung VSS und dem Treiberschaltungsausgang 103 geschaltet. Üblicherweise ist die erste Versorgungsspannung identisch mit der Versorgungsspannung digitaler Schaltungen und beträgt 5 V, kann aber je nach Technologie verschiedene Werte größer 0 V annehmen. Die zweite Versorgungsspannung beträgt üblicherweise 0 V, kann aber auch negative Spannungswerte annehmen.

In Fig.3A sind Dioden eingezeichnet, die sich aufgrund der Transistorstrukturen ergeben. Eine erste Diode 101 bildet sich am P⁺N-Übergang zwischen dem Drain- und dem Bulk-Anschluß des p-Kanal-MOSFET's aus und leitet, sobald das Potential am Treiberschaltungsausgang 103 das Potential am Bulk-Anschluß übersteigt. Eine zweite Diode 102 bildet sich am PN-Übergang zwischen dem Emitter und der Basis des pnp-Bipolartransistors TPNP aus und leitet, wenn das Potential am Treiberschaltungsausgang 103 das Potential an der Basis um die Durchlaßspannung der Diode übersteigt. Bei abgeschalteter erster Versorgungsspannung VDD sollen sowohl die n-Wanne des p-Kanal-MOSFET's als auch die n-Basis des pnp-Bipolartransistors auf der zweiten Versorgungsspannung VSS liegen, so daß die erste 101 und zweite 102 Diode bei einem Potential größer der Diodeneinsatzspannung am Treiberschaltungsausgang 103 leitet und bei einem Potential kleiner der Diodendurchlaßspannung sperrt und kein Strom über die Dioden in die Schaltung abfließt.

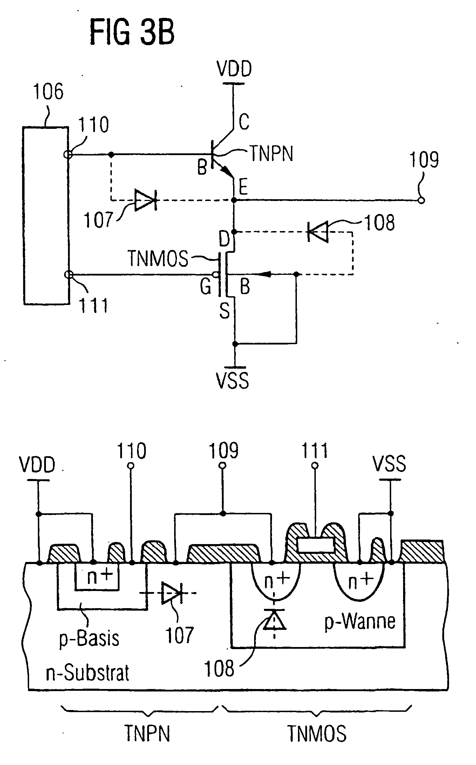

Fig.3B zeigt ein Ausführungsbeispiel, bei dem ein erster Ausgang 110 einer Treiberansteuerung 106 mit der Basis eines npn-Bipolartransistors TNP und ein zweiter Ausgang 111 mit dem Gate-Anschluß eines n-Kanal-MOSFET verbunden ist. Die Laststrecke der npn-Bipolartransistors TNPN ist zwischen der ersten Versorgungsspannung VDD und einem Treiberschaltungsausgang 109 geschaltet. Die Laststrecke des n-Kanal-MOSFET's TNMOS ist zwischen der zweiten Versorgungsspannung VSS und einem Treiberschaltungsausgang 109 geschaltet. Wie bei dem vorherigen Ausführungsbeispiel bildet sich eine erste 107 und zweite 108 Diode zwischen dem Emitter und der Basis des Bipolartransistors bzw. dem Drain- und Bulk-Anschluß des MOSFET's aus. Beide Dioden leiten, wenn das Potential am Treiberschaltungsausgang um die Diodendurchlaßspannüng kleiner ist als das Potential an der Basis bzw. am Bulk-Anschluß. Bei abgeschalteter Versorgungsspannung liegt die p-Wanne und die p-Basis auf der zweiten Versorgungsspannung VSS, so daß bei einer Spannung kleiner der negativen Diodendurchlaßspannung am Treiberschaltungsausgang die Dioden leiten und bei einer Spannung größer der negativen Diodendurchlaßspannung die Dioden sperren und kein Strom aus der Treiberschaltung fließt.

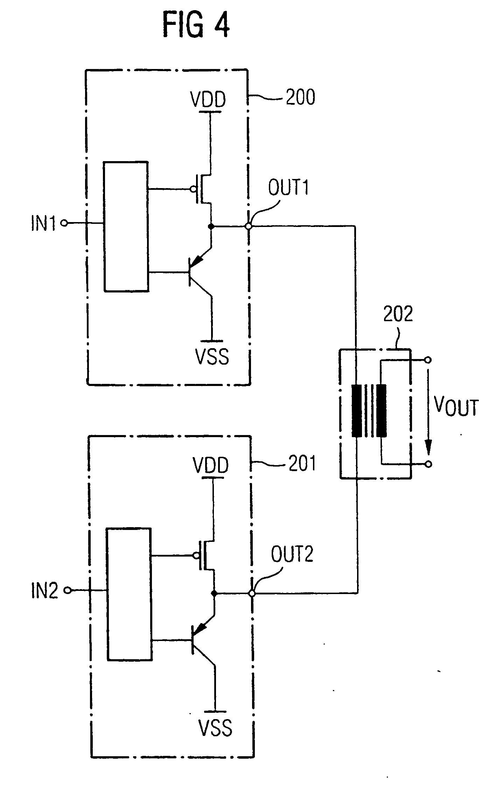

In Fig.4 werden zwei Treiberschaltungen 201 und 202 zur Ansteuerung einer Zweidrahtleitung über eine Übertragerschaltung 202 wie bei der ISDN-S0-Schnittstelle benutzt. Je nachdem welche Polarität die Spannung VOUT am leitungsseitigen Ende des Übertragers hat, sperren die Dioden einer Treiberschaltung immer. Um Strom zu sparen wird bei vielen elektronischen Schaltungen die Versorgungsspannung auf kleinere Werte heruntergeregelt bzw. ganz abgeschaltet, wenn die Schaltung gerade nicht gebraucht wird. Bei der ISDN-S0-Schnittstelle wird die Versorgungsspannung VDD abgeschaltet, wenn das Teilnehmerendgerät inaktiv bzw. abgeschaltet ist. In solchen Fällen sperren die Dioden beider Treiberschaltungen bei einer Spannung VOUT am leitungsseitigen Ende des Übertragers bis zu ca. 1,2 V und in die Treiberschaltung kann kein Strom fließen. Übersteigt die Spannung VOUT einen Wert von 1,2V, so sperrt je nach Polarität der Spannung VOUT wenigstens eine der beiden Treiberschaltungen und der in eine der beiden Treiberschaltungen fließende Strom ist begrenzt.

## Patentansprüche

1. Treiberschaltung, die einen ersten (TPMOS) und zweiten (TPNP) Treibertransistor aufweist, wobei ein erster Ausgang (11) der Treiberansteuerung mit dem Steueranschluß des ersten Treibertransistors und ein zweiter Ausgang (12) der Treiberansteuerung mit dem Steueranschluß des zweiten Treibertransistors verbunden ist und die Laststrecke des ersten Treibertransistors zwischen einer ersten Versorgungsspannung (VDD) und einem Treiberschaltungsausgang (13) und die Laststrecke des zweiten Treibertransistors zwischen einer zweiten Versorgungsspannung (VSS) und dem Treiberschaltungsausgang geschaltet ist, wobei
- die Treiberschaltung eine Strombegrenzereinrichtung (1) aufweist, wobei die Strombegrenzereinrichtung über einen bidirektionalen Steueranschluß (8) mit dem Steueranschluß des ersten Treibertransistors (TPMOS) verbunden ist und die Spannung an dem Steueranschluß des ersten Treibertransistors zur Strombegrenzung einstellt, und
- ein Regeleingang der Strombegrenzereinrichtung über eine Rückkoppelleitung (6) mit dem Treiberschaltungsausgang verbunden ist,
**dadurch gekennzeichnet, daß** die Strombegrenzereinrichtung eine source-gekoppelte Differenzstufe (TN1, TN2, I), einen ersten (TP1) und zweiten (TP2) als Diode geschalteten Lasttransistor sowie einen Steuertransistor (TP4) aufweist, wobei ein erster Eingang der Differenzstufe mit dem Verbindungspunkt (14) einer Spiegeltransistors (TP3) und einer ersten Stromquelle (IREF) verbunden ist und ein zweiter Eingang der Differenzstufe mit dem Regeleingang (10) verbunden ist und ein Ausgang (15) der Differenzstufe über den Steuertransistor (TP4) auf den bidirektionalen Steueranschluß (8) und den Steueranschluß des Spiegeltransistors (TP3) rückgekoppelt ist.

2. Treiberschaltung nach Anspruch 1,
**dadurch gekennzeichnet, daß**
der Regeleingang der Strombegrenzereinrichtung mit einem vorgegebenen Potential ((VDD+VSS)/2) verbunden ist.

3. Treiberschaltung nach Anspruch 1 oder 2,
**dadurch gekennzeichnet, daß**
die Strombegrenzereinrichtung einen Spiegeltransitor (TP3) und eine erste Stromquelle (IREF) aufweist, die einen gemeinsamen Knoten (14) aufweisen.

4. Treiberschaltung nach Anspruch 1,
**dadurch gekennzeichnet, daß**
der erste Treibertransistor ein p-Kanal-MOSFET oder ein p-Kanal-Sperrschicht-Feldeffekttransistor und der zweite Treibertransistor ein pnp-Bipolartransitor ist.

5. Treiberschaltung nach Anspruch 1,
**dadurch gekennzeichnet, daß**
der erste Treibertransistor ein npn-Bipolartransistor und der zweite Treibertransistor ein n-Kanal-MOSFET oder ein n-Kanal-Sperrschicht-Feldeffekttransistor ist.

## Claims

1. Driver circuit having a first (TPMOS) and second (TPNP) driver transistor, a first output (11) of the driver activation arrangement being connected to the control terminal of the first driver transistor and a second output (12) of the driver activation arrangement being connected to the control terminal of the second driver transistor, and the load path of the first driver transistor being connected between a first supply voltage (VDD) and a driver circuit output (13) and the load path of the second driver transistor being connected between a second supply voltage (VSS) and the driver circuit output, in which case
- the driver circuit has a current limiter device (1), the current limiter device being connected to the control terminal of the first driver transistor (TPMOS) via a bidirectional control terminal (8) and setting the voltage at the control terminal of the first driver transistor for the purpose of current limiting, and
- a regulating input of the current limiter device is connected to the driver circuit output via a feedback line (6),
**characterized in that**
the current limiter device has a source-coupled differential stage (TN1, TN2, I), a first (TP1) and second (TP2) load transistor connected as diode, and also a control transistor (TP4), a first input of the differential stage being connected to the junction point (14) of a mirror transistor (TP3) and of a first current source (IREF) and a second input of the differential stage being connected to the regulating input (10), and an output (15) of the differential stage being fed back via the control transistor (TP4) to the bidirectional control terminal (8) and the control terminal of the mirror transistor (TP3).

2. Driver circuit according to Claim 1,
**characterized in that**
the regulating input of the current limiter device is connected to a predetermined potential ((VDD+VSS)/2).

3. Driver circuit according to Claim 1 or 2,
**characterized in that**
the current limiter device has a mirror transistor (TP3) and a first current source (IREF), which have a common node (14).

4. Driver circuit according to Claim 1,
**characterized in that**
the first driver transistor is a p-channel MOSFET or a p-channel junction field-effect transistor and the second driver transistor is a pnp bipolar transistor.

5. Driver circuit according to Claim 1,
**characterized in that**
the first driver transistor is an npn bipolar transistor and the second driver transistor is an n-channel MOSFET or an n-channel junction field-effect transistor.

## Revendications

1. Circuit de pilotage comprenant un premier (TPMOS) et un deuxième (TPNP) transistor pilote, une première sortie (11) de la commande pilote étant reliée avec la borne de commande du premier transistor pilote, et une deuxième sortie (12) de la commande pilote étant reliée avec la borne de commande du deuxième transistor pilote, le chemin de charge du premier transistor pilote étant connecté entre une première tension d'alimentation (VDD) et une sortie du circuit de pilotage (13) et le chemin de charge du deuxième transistor pilote étant connecté entre une deuxième tension d'alimentation (VSS) et la sortie du circuit de pilotage,
- le circuit de pilotage comprend un dispositif limiteur de courant (1), qui est relié avec la borne de commande du premier transistor pilote (TPMOS), via une borne de commande bidirectionnelle (8), et règle la tension de la borne de commande du premier transistor pilote pour limiter le courant, et
- une entrée de réglage du dispositif limiteur de courant est reliée avec la sortie du circuit de pilotage via une ligne de rétroaction (6),
**caractérisé en ce que**
le dispositif limiteur de courant comprend un étage différentiel couplé à la source (TN1, TN2, 1), un premier (TP1) et un deuxième (TP2) transistor de charge connectés comme diode ainsi qu'un transistor de commande (TP4), une première entrée de l'étage différentiel étant reliée avec le point de liaison (14) d'un transistor miroir (TP3) et d'une première source de courant (IREF), et une deuxième entrée de l'étage différentiel étant reliée avec l'entrée de réglage (10), une sortie (15) de l'étage différentiel étant réinjectée, via le transistor de commande (TP4), sur la borne de commande (8) bidirectionnelle et la borne de commande du transistor miroir (TP3).

2. Circuit de pilotage selon la revendication 1,
**caractérisé en ce que**
l'entrée de réglage du dispositif limiteur de courant est reliée avec un potentiel prédéterminé ((VDD+VSS)/2).

3. Circuit de pilotage selon la revendication 1 ou 2,
**caractérisé en ce que**
le dispositif limiteur de courant comprend un transistor miroir (TP3) et une première source de courant (IREF) qui comprennent un noeud (14) commun.

4. Circuit de pilotage selon la revendication 1,
**caractérisé en ce que**
le premier transistor pilote est un MOSFET canal P ou un transistor à effet de champ à jonction de grille canal P et le deuxième transistor pilote est un transistor bipolaire PNP.

5. Circuit de pilotage selon la revendication 1,
**caractérisé en ce que**
le premier transistor pilote est un transistor bipolaire NPN et le deuxième transistor pilote est un MOSFET canal N ou un transistor à effet de champ à jonction de grille canal N.
